(19) **Europäisches Patentamt**

**European Patent Office**

**Office européen des brevets**

(11) **EP 1 052 699 A1**

(12) **EUROPEAN PATENT APPLICATION**
published in accordance with Art. 158(3) EPC

(43) Date of publication:
15.11.2000 Bulletin 2000/46

(51) Int. Cl.[7]: **H01L 29/78**

(21) Application number: 98955939.8

(86) International application number:
**PCT/JP98/05323**

(22) Date of filing: 26.11.1998

(87) International publication number:
**WO 00/31800 (02.06.2000 Gazette 2000/22)**

(84) Designated Contracting States:
**DE FR GB IT**

(71) Applicant:
**MITSUBISHI DENKI KABUSHIKI KAISHA
Tokyo 100-8310 (JP)**

(72) Inventor:
**HARUGUCHI, Hideki
Mitsubishi Denki K. K.
Chiyoda-ku Tokyo 100-8310 (JP)**

(74) Representative:
**Sajda, Wolf E., Dipl.-Phys. et al
MEISSNER, BOLTE & PARTNER
Postfach 86 06 24
81633 München (DE)**

(54) **SEMICONDUCTOR DEVICE AND FABRICATION METHOD THEREFOR**

(57) In order that the tradeoff between on state voltage and switching-off loss can be improved and a PT type IGBT element can be formed even with the use of a single crystal wafer, in an insulating gate bipolar transistor suitable for power switching element, there is provided a semiconductor device which comprises a first region of a first conductivity type, a second region of a second conductivity type disposed on the first region, a third region of the first conductivity type in the second region, a fourth region of the second conductivity type in the third region, and a low resistance region that prevents the extension of a depletion layer, disposed on the first region side in the second region. This semiconductor device is characterized in that the low resistance region is formed by implanting non-impurity ion into a region where the low resistance region is desired, to obtain a recombination center defect region, and performing a heat treatment of the defect region, in order to obtain a low resistance.

FIG.7

EP 1 052 699 A1

Printed by Xerox (UK) Business Services
2.16.7 (HRS)/3.6

## Description

### Technical Field

This invention relates to a semiconductor device suitable for power switching elements such as insulated gate bipolar transistors and, in particular, punch-through type insulating gate bipolar transistors with a low resistance layer preventing the extension of a depletion layer, as well as a method of manufacturing the same.

### Background Art

Recently IGBT (insulating gate bipolar transistor) elements which are constructed by the combination of an insulated gate field effect transistor and a bipolar transistor have been noted as a power switching element.

As exemplary of this IGBT element, there are non punch-through type (NPT type) IGBT element in which an N-type base region is designed to be thick in order to prevent a depletion layer, which extends from a P-type base region to a P-type collector region in a rated voltage application, from reaching through from the N-type base region to the P-type collector region; and punch-through type (PT type) IGBT elements in which an $N^+$ low resistance layer for avoiding the extension of a depletion layer is disposed in the vicinity of a P-type collector region in an N-type base region, and it is designed so that the depletion layer which extends from a P-type base region to the P-type collector region in a rated voltage application is blocked by the $N^+$ low resistance layer.

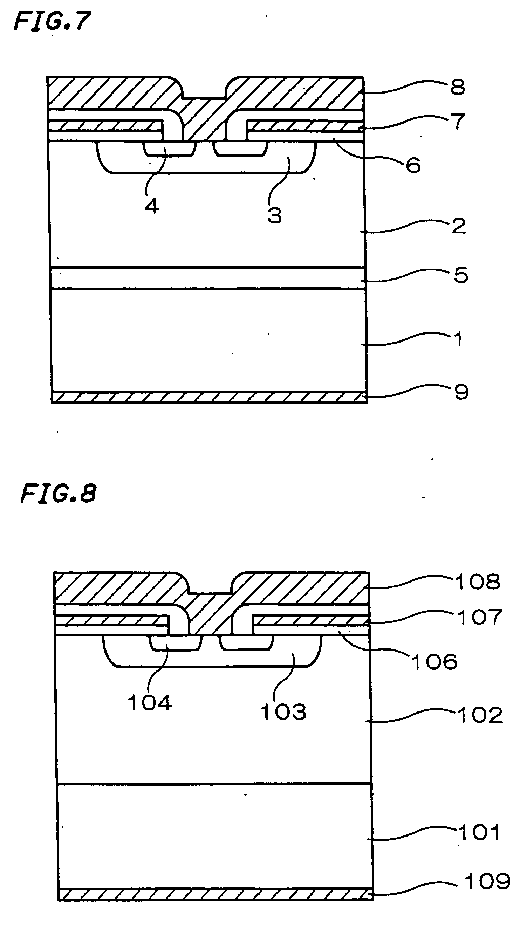

This NPT type IGBT element comprises, as shown in Fig. 8, an N-type base region 102 overlies a P-type collector region 101, and a P-type base regions 103 which are selectively disposed on the opposite side of the P-type collector region 101 in the N-type base region 102. In the surface of the P-type base region 103, there are disposed N-type emitter regions 104 which comprise at least two regions spaced a predetermined distance from each other. An emitter electrode 108 makes contact with the upper part of the P-type collector region 103 between the N-type emitter regions 104, and with the upper part of the N-type emitter regions 104 (a contact area).

A gate electrode 107 is disposed on the P-type base region 103 and the N-type emitter regions 104 except for the contact area, with a gate oxide film 106 interposed. An insulating film overlies the gate electrode 107. The insulating film is formed so as to cover the side faces of the gate oxide film 106 and the gate electrode 107 near the contact area. An emitter electrode 108 is disposed on the insulating film such that it makes contact with the P-type base region 103 and N-type emitter region 4, respectively, with the contact area interposed. A collector electrode 109 overlies the P-type collector region 101.

In the NPT type IGBT element so constructed, it is necessary that the N-type base region 102 is made thick in order to prevent a depletion layer, which extends into the N-type base region 102 from the contact area between the P-type base region 103 and N-type base region 102 in a rated voltage application, from reaching through to the P-type collector region 101. As a result, in on state, the resistance value of the N-type base region 102 is increased and on state voltage is thus increased. Therefore, the NPT type IGBT elements suffer from the problem that the tradeoff between on state voltage and turn-off loss is inferior to that of the PT type IGBT elements (particularly for low breakdown voltage IGBT elements).

In contrast to the NPT type IGBT elements, in the PT type IGBT elements the N-type base region can be designed to be thin, and therefore, the tradeoff between on state voltage and turn-off loss is superior to that of the NPT type IGBT elements (particularly for low breakdown voltage IGBT element). However, it should be noted that a wafer formed by epitaxial growth (hereinafter referred to as "epitaxial wafer") is needed in forming an $N^+$ low resistance layer, and thus additional cost may be incurred. Hereafter, the PT type IGBT elements will be described.

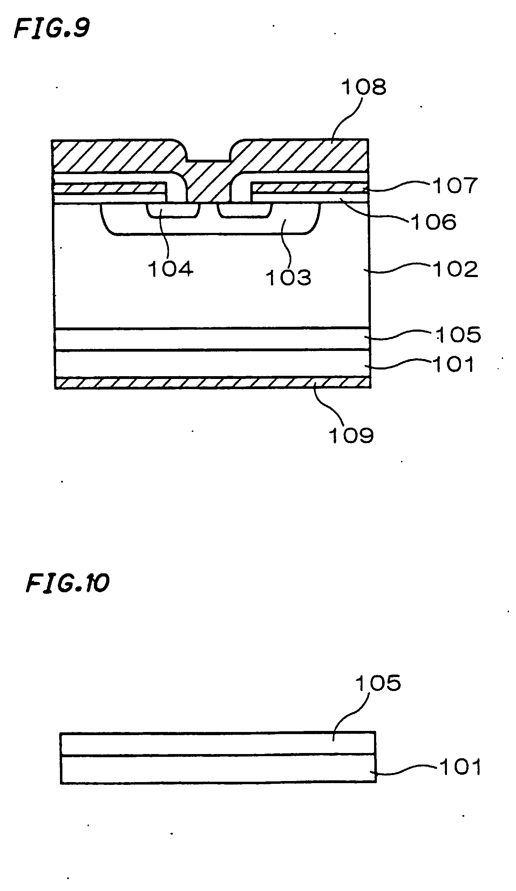

Fig. 9 is a cross section illustrating a conventional PT type IGBT element as disclosed in, for example, Japanese Patent Application Laid-Open No. 10-50724 (1998). As shown in Fig. 9, an $N^+$ low resistance layer 105 overlies a P-type collector region 101 having a predetermined impurity concentration, and an N-type base region 102 having a lower impurity concentration than the P-type collector region 101, is disposed on the $N^+$ low resistance layer 105. P-type base region 103 having a high impurity concentration is selectively disposed on the opposite side of the P-type collector region 101 in the N-type base region 102. N-type emitter regions 104 are selectively disposed in the surface of the P-type base region 103. Others are similar to those in Fig. 8, and therefore description thereof is omitted.

Description will now be given of a method of manufacturing a semiconductor device that is the PT-type IGBT element shown in Fig. 9. Figs. 10 to 12 are process drawings illustrating a method of manufacturing the semiconductor device shown in Fig. 9.

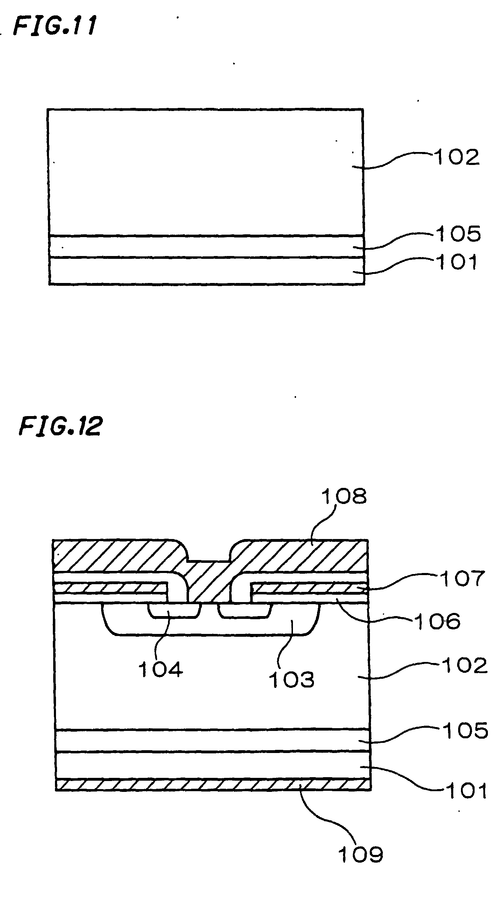

Referring to Figs. 10 and 11, firstly an N-type epitaxial layer is grown on a P-type semiconductor substrate (P-type collector region 101) by epitaxial method, thereby to form an $N^+$ low resistance layer 105. Thereafter, an N-type semiconductor is stacked on the $N^+$ low resistance layer 105, thereby to form an N-type base region 102 with high resistance.

Referring to Fig. 12, a silicon oxide film which will become a gate oxide film 106 is formed on the N-type base region 102, and polysilicon which will become a gate electrode 107 is deposited on the silicon oxide film. Subsequently, the central area thereof is selectively opened to give an opening, through which a P-type impurity such as boron is implanted and diffused to form a P-type base region 103 within the N-type base region 102. Similarly, through the opening, an N-type impurity such as phosphorus is selectively implanted and diffused into the P-type base region 103, thereby to form N-type emitter regions 104. After the P-type base region 103 and N-type emitter regions 104 are formed as described, from above the epitaxial wafer, an insulating film such as of silicon oxide is formed and the central area thereof is then opened so that the surface of the P-type base region 103 and N-type base regions 104 are respectively exposed to form a contact area. Subsequently, an emitter electrode 108 is formed so that it makes contact with the P-type base region 103 and N-type emitter regions 104, respectively, with the contact area interposed. Further, a collector electrode 109 composed of metal, e.g., aluminum, is formed on the P-type collector region 101.

In this PT type IGBT element, it is possible to maintain a rated voltage by disposing the N$^+$ low resistance layer between the P-type collector region and N-type base region even when the thickness of the N-type base region is reduced. Therefore, the N-type base region can be made thinner than the NPT type IGBT element as described, and the tradeoff between on state voltage and turn-off loss can be improved. However, the necessity to form the N$^+$ low resistance layer requires that the IGBT element be manufactured by using an epitaxial wafer that is expensive.

When a single crystal wafer used in the NPT type IGBT element is adopted in the place of the epitaxial wafer, it is necessary that, from one main surface of the wafer, an N-type impurity be implanted and diffused to form an N$^+$ low resistance layer, and, from this main surface, a P-type impurity be implanted and diffused to form a P-type collector region. In this event, however, it is difficult to control the diffusion depth in the N-type base region and P-type base region. In the IGBT element having a low breakdown voltage, the total thickness of the wafer is increased with the purpose of eliminating the cracking of the wafer. So, when the diffusion depth of the P-type collector region is increased, there may cause the problems of long diffusion time and long term of manufacture.

In the case of manufacturing the IGBT element of a low breakdown voltage class, in order to achieve low on state voltage, it is necessary to reduce the thickness of the N-type base region. This, however, causes a reduction in the thickness of the single crystal wafer. As a result, the wafer is susceptible to crack during the wafer process, and it is thus difficult to manufacture with the use of a single crystal wafer.

The present invention seeks to resolve the foregoing problems and provide a semiconductor device that can improve the tradeoff between on state voltage and switching-off loss, and can be manufactured with the use of a single crystal wafer, as well as a method of manufacturing the same.

The present invention also provides a semiconductor device with which, even when the thickness of an N-type base region is reduced as the IGBT element has a lower breakdown voltage, an N-type wafer having on a surface thereof a P-type collector region can retain its thickness sufficiently, thereby to prevent the wafer from cracking during the wafer process, as well as a method of manufacturing the same.

**Disclosure of Invention**

According to the present invention, there is provided a semiconductor device which comprises a first region of a first conductivity type, a second region of a second conductivity type adjacent to the first region, a third region of the first conductivity type adjacent to the second region, and a fourth region of the second conductivity type adjacent to the third region, so that current is conducted by bringing a transistor formed by the first, second and third regions, into on state, characterized in that a low resistance layer for preventing a depletion layer from extending from the second region, is disposed in the vicinity of the first region within the second region, and in that the low resistance layer is composed of a low resistance layer formed by means of non-impurity ion irradiation with subsequent heat treatment,

Alternatively, according to the invention, there is provided a method of manufacturing a semiconductor device comprising the steps of: forming, in a singe crystal substrate, a first region of a first conductivity type and a second region of a second conductivity type, each having a predetermined thickness and being adjacent to each other; forming a lattice defect region by irradiating non-impurity ion into the vicinity of the first region within the second region; forming a low resistance layer which prevents a depletion layer from extending from the second region, in the vicinity of the first region within the second region, by performing a heat treatment of the lattice defect region; and forming a third region of the first conductivity type adjacent to the second region, and a fourth region of the second conductivity type adjacent to the third region.

The present invention was accomplished based on the finding that a low resistance layer provided for suppressing a depletion layer in the conventional punch-through type IGBT can be formed in a single crystal substrate readily and efficiently by subjecting a second region to non-impurity ion irradiation and heat treatment, instead of epitaxial technique; and on the experimental evidence that this low resistance layer can control the extension of the depletion layer which extends from the junction area between the second region and a third region, toward a first region and into the second region. Each of the first, second, third and fourth regions of the present invention can be readily formed in a single crystal substrate by means of impurity implantation and/or diffusion. It is therefore possible to form all these regions in a single crystal substrate by adopting the low resistance layer as described. With a conventional thick single crystal substrate as it is, only by changing the diffusion depth of a P-type collector region and the implantation depth of non-impurity ion, the thickness of an N-type base region can be designed freely, thus permitting application to low breakdown voltage products of not exceeding 1400 V class. In addition, the extension of the depletion layer that extends to the second region when a rate voltage is applied, can be restricted by the low resistance layer, and therefore, the second region can be made thinner than the NPT type IGBT element. This enables to configure a semiconductor device with low on state voltage, as in the PT type IGBT element using the epitaxial wafer. This also produces the advantage that the semiconductor device can be manufactured at low cost, without employing a conventional tedious epitaxial technique.

The low resistance layer of this invention is formed by non-impurity ion irradiation and heat treatment. Examples of the non-impurity ion are helium and proton. Of these, proton is preferred because it is easily made into a donor by heat treatment. The non-impurity ion irradiation may be performed from the first region side, with the first region interposed. Alternatively, it may be performed from the second region side. The energy of the irradiation is so set that the range of the non-impurity ion extends to the vicinity of the first region within the second region, thereby to form a lattice defect region in the vicinity of the first region. Heat treatment is performed under the following conditions that the lattice defect region is made into a donor, and this region has a resistance value sufficiently lower than the area free from any lattice defect. Usually it is preferably from 320 °C to 380 °C. Appropriate resistance value of the low resistance layer depends on the design requirements such as the resistance of other regions, and their respective thickness, therefore it is difficult to specify unconditionally, but suitable resistance is usually about 0.05 to 50 $\Omega$ cm. The thickness of the low resistance layer is determined properly according to the design requirements and, more particularly, the correlation between the thickness of the second region and the thickness of the semiconductor wafer. However, suitable thickness is usually from about 5 $\mu$m to 50 $\mu$m.

In the present invention, the regions other than the low resistance layer can be usually formed by performing ion implantation or diffusion into a single crystal semiconductor substrate (wafer). As their formation process itself, the conventional method as is used in the non punch-through type IGBT, can be adopted. For instance, the first and second regions can be formed in a single step that an impurity ion of a second conductivity type is implanted or diffused from a surface of a semiconductor wafer of a first conductivity type. The third and fourth regions can also be formed by means of ion implantation or diffusion.

As noted above, the respective regions in the semiconductor device of the invention can be formed in a single crystal semiconductor substrate, and such a configuration is novel and useful per se, as the punch-through type IGBT. Accordingly, the present invention also provides a semiconductor device which comprises a first region of a first conductivity type, a second region of a second conductivity type adjacent to the first region, a third region of the first conductivity type adjacent to the second region, and a fourth region of the second conductivity type adjacent to the third region, so that current is conducted by bringing a transistor formed by the first, second and third regions, into on state, characterized in that a low resistance layer which prevents a depletion layer from extending from the second region is disposed in the vicinity of the first region within the second region, and in that the first and second regions and the low resistance layer are formed in a single crystal substrate.

As the single crystal wafer, one which has a thickness of 200 $\mu$m to 450 $\mu$m is inexpensively available and simple in handling. It is advantageous to the semiconductor device of the invention that such a wafer can be used as it is, to obtain the punch-through type IGBT.

When a semiconductor device of the invention is configured as an IGBT, the first region is connected to a collector electrode, an emitter electrode is connected to the third and fourth regions, and a gate electrode is disposed on the third and fourth regions, with a gate insulating film interposed. Their shapes and the like are set suitably so as to function appropriately as an IGBT. The fourth region is usually disposed in the third region, so that the emitter electrode is connected to the third and fourth regions, respectively.

As previously described, the semiconductor device of the invention is useful particularly when it is configured as an IGBT. The semiconductor device is also applicable to power switching elements having the PNPN (or NPNP) structure, such as thyristors, TRIACs, etc.

**Brief Description of Drawings**

Fig. 1 is a cross section illustrating the configuration of a semiconductor device according to a first preferred embodiment of the present invention;
Fig. 2 is a diagram illustrating a method of manufacturing a semiconductor device according to the first preferred embodiment;
Fig. 3 is other diagram illustrating the method of manufacturing a semiconductor device according to the first preferred embodiment;
Fig. 4 is other diagram illustrating the method of manufacturing a semiconductor device according to the first preferred embodiment;
Fig. 5 is other diagram illustrating the method of manufacturing a semiconductor device according to the first preferred embodiment;

Fig. 6 is a diagram illustrating a method of manufacturing a semiconductor device according to a second preferred embodiment;

Fig. 7 is a diagram illustrating the method of manufacturing a semiconductor device according to the second preferred embodiment;

Fig. 8 is a cross section illustrating the configuration of a conventional semiconductor device;

Fig. 9 is another cross section illustrating the configuration of the conventional semiconductor device;

Fig. 10 is a diagram illustrating a conventional method of manufacturing a semiconductor device;

Fig. 11 is other diagram illustrating the conventional method of manufacturing a semiconductor device; and

Fig. 12 is other diagram illustrating the conventional method of manufacturing a semiconductor device.

**Best Mode for Carrying Out the Invention**

For purposes of description in further detail, the present invention will be described in accordance with the accompanying drawings. The present invention is concerned with semiconductor devices, such as IGBT (insulating gate bipolar transistor) elements which are constructed by the combination of an insulated gate field effect transistor and a bipolar transistor, as a power switching element, and is particularly concerned with the PT type IGBT elements.

First Preferred Embodiment

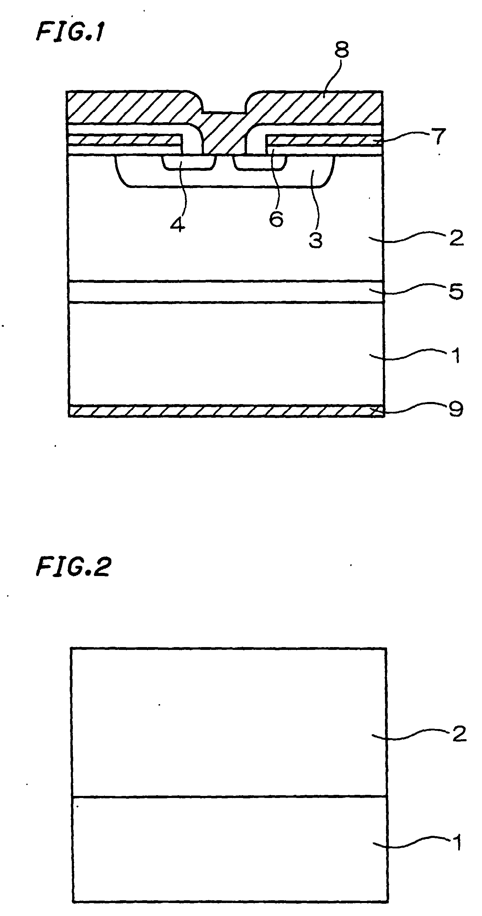

Fig. 1 is a cross section illustrating the configuration of the PT type IGBT element which is a semiconductor device according to a first preferred embodiment of the invention. As shown in Fig. 1, an $N^+$ low resistance layer 5 having a lower resistance value than an N-type base region 2, is disposed on a P-type collector region 1 having a predetermined impurity concentration, and an N-type base region 2 having a lower impurity concentration than the P-type collector region 1, is disposed on the $N^+$ low resistance layer 5. Herein, the $N^+$ low resistance layer 5 is not formed by epitaxial growth as has been conventional, but is formed in the following manner that the ion irradiation of non-impurity ion, e.g., proton, is performed to form a recombination defect region which is then made into a donor by annealing. The resistance value of the $N^+$ low resistance layer 5 is 0.05 to 50 $\Omega$ cm, preferably 10 to 30 $\Omega$ cm. P-type base region 3 with high impurity concentration is selectively disposed on the opposite side of the P-type collector region 1 in the N-type base region 2. In the surface of the P-type base region 3, there are disposed N-type emitter regions 4 which comprise at least two regions spaced a predetermined distance from each other. An emitter electrode 8 makes contact with the upper part of the P-type collector region 3 between the N-type emitter regions 4, and with the upper part of the N-type emitter regions 4 (a contact area). Herein, the N-type emitter regions 4 are disposed in a plurality of region spaced a predetermined distance with each other (more specifically, disposed radially). However, no special limitation is imposed on shape, and it may be in annular shape. Alternatively, the N-type emitter regions 4 may be disposed in a single region, instead of a plurality of regions.

A gate electrode 7 is disposed on the P-type base region 3 and the N-type emitter regions 4 except for the contact area, with a gate oxide film 6 interposed. An insulating film overlies the gate electrode 7. The insulating film is formed so as to cover the side surfaces of the gate oxide film 6 and the gate electrode 7 near the contact area. An emitter electrode 8 is disposed on the insulating film such that it makes contact with the P-type base region 3 and the N-type emitter regions 4, respectively, with the contact area interposed. A collector electrode 9 overlies the P-type collector region 1.

As a silicon substrate which will become the base of the N-type base region 2, there is used, in place of an epitaxial wafer as has been conventional, an N-type single crystal wafer, for example, a wafer manufactured by FZ method or CZ method (Hereinafter, the wafer formed by FZ method and the wafer formed by CZ method are referred to as "FZ wafer" and "CZ wafer," respectively.).

Description will now be given of a method of manufacturing the semiconductor device shown in Fig. 1. Figs. 2 to 5 are process drawings illustrating a method of manufacturing the semiconductor device of Fig. 1.

Referring to Fig. 2, firstly, a P-type impurity such as boron is implanted and diffused into one main surface of an N-type single crystal wafer (an FZ wafer is used herein) which will become the base of an N-type base region 2, thereby to form a P-type collector region 1. The thickness of the FZ wafer is set to 100 μm to 500 μm preferably 200 μm to 450 μm in order that no breakage nor warpage of the FZ wafer occurs in the process of manufacturing the semiconductor device. The diffusion thickness of the P-type impurity is controlled depending on the thickness of the wafer, so that thickness $W_B$ of the N-type base region 2 becomes an optimum value per breakdown voltage class, as hereinafter described. In order to avoid that on state voltage increases in on state, it is designed so that thickness $W_B$ of the N-type base region 2 falls within the range given in the following equation (1), for example, 145 μm to 155 μm when the maximum rated voltage of the PT type IGBT element is 1200 V, and 160 μm to 70 μm when it is 1400V.

$$W_B \leqq \{(2\varepsilon_S \cdot \varepsilon_O(V_{bi}-V))/(q \cdot N_B)\}^{1/2} \qquad (1)$$

where $\varepsilon_S$ is the relative dielectric constant of silicon; $\varepsilon_O$ is the dielectric constant of vacuum; $V_{bi}$ is the internal voltage at the PN junction between the P-type base region 3 and N-type base region 2; V is the voltage between the collector electrode 9 and emitter electrode 8; q is the quantity of electric charge; and $N_B$ is the impurity density of the N-type base region 2.

If the thickness of the P-type collector region 1 is reduced as has been conventional, the wafer thickness is reduced because the N-type base region 2 is formed so as to have a small thickness $W_B$ as described. As a result, the wafer breakage or warpage may occur and thus the production efficiency is lowered considerably. Therefore, in this preferred embodiment it is designed so that the wafer is made thick as a whole, by reducing the thickness of the N-type base region 2, and, by increasing the thickness of the P-type collector region 1.

The P-type collector region 1 may be formed so as to have a predetermined thickness, in accordance with the thickness of the N-type base region 2. In this preferred embodiment there is used one in which the FZ wafer has a specific resistance of 70 Ω cm, however, an optimum value of specific resistance depends on the breakdown voltage class. For 1200 V class, it is preferably from 60 Ω to 80 Ω

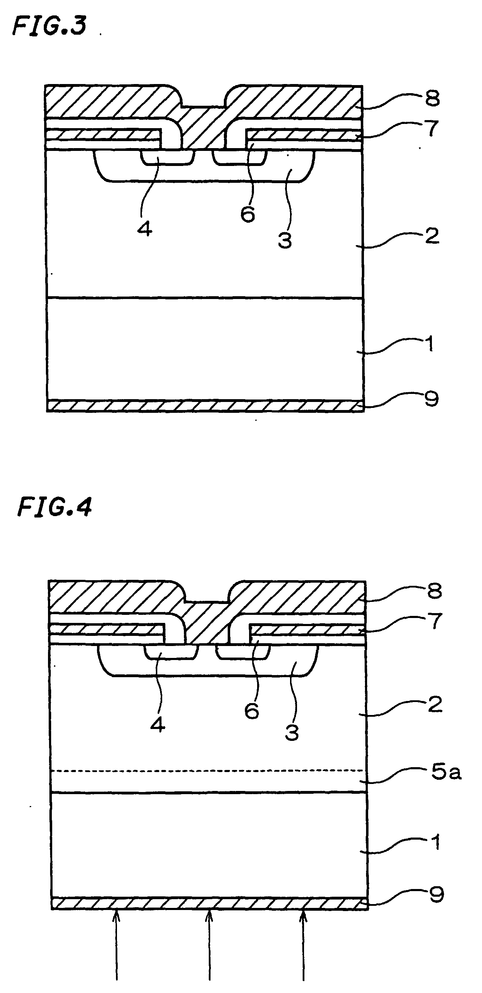

Referring to Fig. 3, a silicon oxide film which will become a gate oxide film 6 is formed on the main surface of the opposite side of the N-type base region 2. Polysilicon which will become a gate electrode 7 is deposited on the silicon oxide film, and the central area thereof is selectively opened to give an opening, through which a P-type impurity such as boron is then implanted and diffused to form a P-type base region 3 in the N-type base region 2. Similarly, through the opening, an N-type impurity such as phosphorus is selectively implanted and diffused into the P-type base region 3, thereby to form N-type emitter regions 4. After the P-type base region 3 and N-type emitter regions 4 are formed in this manner, an insulating film such as of silicon oxide is formed from above the FZ wafer, and the central area thereof is opened so that the surface of the P-type base region 3 and N-type base regions 4 are exposed respectively, thereby to form a contact area. Subsequently, an emitter electrode 8 is formed so as to make contact with the P-type base region 3 and N-type emitter regions 4, respectively, with the contact area interposed. Further, a collector electrode 9 composed of metal, e.g., aluminum, is formed on the P-type collector region 1.

Referring to Fig. 4, after forming the MOS structure as described, from the P-type collector region 1 side, non-impurity ion such as proton is irradiated under the conditions, for example, at an accelerating voltage of 4.5 MeV, and a dose of $1.5 \, E^{11}$ cm$^{-2}$ to $1 \, E^{13}$ cm$^{-2}$. Thereby, a crystal defect region 5a is formed on the P-type collector region 1 side in the N-type base region 2. This proton irradiation is performed by using an Al mask or the like, so that the peak of the crystal defect is located near the boundary between the N-type base region 2 and P-type collector region 1. It should be noted that the non-impurity ion to be irradiated for forming the crystal defect is not limited to proton. Specifically, it is possible to employ any particles, e.g., helium, which can form a crystal defect in the low resistance layer region, without adversely affecting the crystal structure of the P-type collector region 1, and which can be made into a donor by heat treatment. However, proton is preferred because it is easily made into a donor by heat treatment.

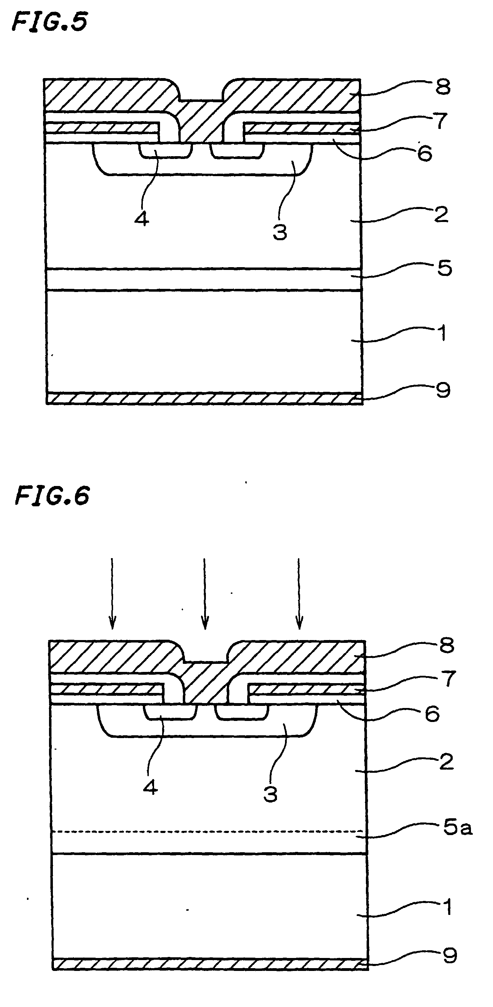

After the crystal defect region 5a is formed by the non-impurity ion as described, as shown in Fig. 5, annealing is performed at about 340 °C, so that the crystal defect region 5a is made into a donor, and an N$^+$ low resistance layer 5 is formed on the P-type collector region 1 side in the N-type base region 2. The annealing may be carried out at any temperature at which the formed lattice defect is made into a donor, but it is usually in the range of 320 °C to 380 °C.

Operation of the semiconductor device shown in Fig. 1 will be described below.

In order to bring the PT type IGBT element into on state, with the emitter electrode 8 acting as earth, a positive voltage is applied to the collector electrode 9, and voltage (a gate voltage) is applied to the gate electrode 7, so that current flows between the collector electrode 9 and emitter electrode 8.

Meanwhile, no current flows (off state) in the state that the gate voltage is low and thus no N-type channel is formed in the P-type base region 3 underlying the gate insulating film 6. On the other hand, current flows between the collector electrode 9 and emitter electrode 8, resulting in on state, when the gate voltage exceeds a voltage (hereinafter referred to as "Vth") at which an N-type channel is formed in the P-type base region 3 underlying the gate insulating film 6.

In this event, since the N-type base region 2 in the PT type IGBT element is made thin, the resistance value of the N-type base region can be reduced, thereby lowering on state voltage in on state.

In order to bring the IGBT element into off state, the voltage applied to the gate electrode 6 in on state is reduced to 0V. Upon this, from the boundary between the P-type base region 3 and N-type base region 2, a depletion layer extends, but it mainly extends to the N-type base region 2, because the N-type base region 2 has a lower impurity concentration than the P-type base region 3. However, as shown in Fig. 1, the N$^+$ low resistance layer 5, which has the same conductivity type as the N-type base region 2 and has a low resistivity, is disposed between the P-type collector region 1 and N-type base region 2. Hence, the N$^+$ low resistance layer 5 functions to prevent the depletion layer from reaching through to the P-type collector region 1, when a rated voltage is applied.

Thus, in the semiconductor device of this preferred embodiment, the low resistance layer of the N-type base region in the PT type IGBT element is formed in the following manner that the recombination center defect region formed by non-impurity ion implantation is subjected to heat treatment so that it is made into a donor and has a low resistance. It is therefore possible to form the low resistance layer after the P-type collector region and N-type base region are formed on a semiconductor wafer. In addition, since the thickness of the P-type collector region can be changed freely in accordance with the thickness of the N-type base region, the wafer can be made in such a thickness that it is possible to avoid breakage or warpage of the wafer, thus facilitating the process. Furthermore, even in the use of a single crystal wafer, the thickness of the N-type base region can be reduced, which enables to form the PT type IGBT element.

Second Preferred Embodiment

In the first preferred embodiment the lattice defect region is formed by non-impurity ion irradiation from the P-type collector region side, whereas in a second preferred embodiment a lattice defect region is formed by non-impurity ion irradiation from the main surface of the opposite side of the P-type collector region (i.e., the N-type emitter region side).

Figs. 6 and 7 are process drawings illustrating a method of manufacturing a PT type IGBT element that is a semiconductor device of the second preferred embodiment. The semiconductor device of this embodiment is similar to the first preferred embodiment, except for its manufacturing method. Therefore, description of the semiconductor device is omitted.

In a similar manner as shown in Figs. 2 and 3 in the first preferred embodiment, various regions (except for a low resistance layer), a MOSFET and electrodes are firstly formed on a FZ wafer.

Referring to Fig. 6, non-impurity ion such as proton is irradiated from the opposite side of a P-type collector region 1 (i.e., from the N-type emitter region 4 side) in the FZ wafer, under the conditions, for example, at an accelerating voltage of 4.5 MeV, and a dose of 1.5 $E^{11}$ cm$^{-2}$ to 1 $E^{13}$ cm$^{-2}$ Thereby, a crystal defect region 5a is formed on the P-type collector region 1 in the N-type base region 2. This proton irradiation is performed by using an Al mask or the like, so that the peak of the crystal defect is located near the boundary between the N-type base region 2 and P-type collector region 1. It should be noted that the non-impurity ion to be irradiated for forming the crystal defect is not limited to proton. Specifically, it is possible to employ any particles, e.g., helium, which can form a crystal defect in the low resistance layer region, without adversely affecting the crystal structure of various regions on the wafer.

Referring to Fig. 7, after the crystal defect region 5a is formed by the non-impurity ion implantation as described, annealing is performed at about 340 °C, so that the crystal defect region 5a is made into a donor, thereby to form a low resistance layer 5 on the P-type collector region 1 side in the N-type base region 2, resulting in a PT type IGBT element.

The first and second preferred embodiments are described as applied to the N-type single crystal wafer formed by allowing a P-type impurity to diffuse into one main surface. However, it is to be understood that these are not intended to be limiting of the invention, but, on the contrary, these may be applied to a P-type single crystal wafer formed by allowing an N-type impurity to diffuse into one main surface.

In the first and second preferred embodiments, the low resistance layer is formed after forming the respective regions, MOSFET and electrodes, however, it is to be understood that this is not intended to be limiting of the invention. Prior to the formation of the MOSFET or the respective electrodes, a lattice defect region may be formed by non-impurity ion irradiation. Alternatively, annealing to be performed after forming a lattice defect region may be executed in parallel with other heat treatment.

In addition, the semiconductor device of the invention is useful particularly when it is configured as an IGBT, as previously described. This semiconductor device is also applicable to power switching elements having the PNPN (or NPNP) structure, such as thyristors, TRIACs, etc.

**Industrial Applicability**

Thus, the semiconductor devices according to the invention are concerned with the IGBT elements and, in particular, the PT type IGBT elements, as well as the manufacturing method thereof, and are suitable for use in the PT type IGBT elements in which a single crystal wafer is employed as a semiconductor wafer.

**Claims**

1. A semiconductor device comprising a first region of a first conductivity type, a second region of a second conductivity type adjacent to said first region, a third region of said first conductivity type adjacent to said second region, and a fourth region of said second conductivity type adjacent to said third region, so that current is conducted by bringing a transistor formed by said first, second and third regions, into on state,

   characterized in that a low resistance layer which prevents a depletion layer from extending from said second region is disposed in the vicinity of said first region within said second region, and in that said low resistance layer is composed of a low resistance layer formed by non-impurity ion irradiation and heat treatment.

2. The semiconductor device according to claim 1, wherein said non-impurity ion is one selected from helium and proton.

3. The semiconductor device according to claim 1, wherein said low resistance layer has a resistance value of 0.05 to 50 Ω cm.

4. The semiconductor device according to claim 1, wherein a collector electrode is connected to said first region, an emitter electrode is connected to said third and fourth regions, and a gate electrode is disposed above said fourth region with an insulating film interposed, thereby to form an insulating gate bipolar transistor (IGBT).

5. A semiconductor device comprising a first region of a first conductivity type, a second region of a second conductivity type adjacent to said first region, a third region of said first conductivity type adjacent to said second region, and a fourth region of said second conductivity type adjacent to said third region, so that current is conducted by bringing a transistor formed by said first, second and third regions, into on state,

characterized in that a low resistance layer that prevents a depletion layer from extending from said second region is disposed in the vicinity of said first region within said second region, and in that said first and second regions and said low resistance layer are formed in a single crystal substrate.

6. The semiconductor device according to claim 5, wherein said low resistance layer is composed of a low resistance layer formed by non-impurity ion irradiation and heat treatment.

7. The semiconductor device according to claim 5, wherein said non-impurity ion is one selected from helium and proton.

8. The semiconductor device according to claim 5, wherein a collector electrode is connected to said first region, an emitter electrode is connected to said third and fourth regions, and a gate electrode is disposed above said fourth region with an intervening insulating film, thereby to form an insulating gate bipolar transistor (IGBT).

9. A method of manufacturing a semiconductor device comprising the steps of:

forming, in a single crystal substrate, a first region of a first conductivity type and a second region of a second conductivity type which are adjacent to each other and have a predetermined thickness;
forming a lattice defect region by irradiating non-impurity ion into the vicinity of said first region within said second region;
forming a low resistance layer that prevents a depletion layer from extending from said second region, in the vicinity of said first region within said second region, by performing heat treatment of said lattice defect region; and
forming a third region of said first conductivity type adjacent to said second region, and a fourth region of said second conductivity type adjacent to said third region.

10. The method of manufacturing a semiconductor device according to claim 9, wherein said non-impurity ion is one selected from helium and proton.

11. The method of manufacturing a semiconductor device according to claim 9, wherein said non-impurity ion irradiation is performed from said first region side, with said first region interposed.

12. The method of manufacturing a semiconductor device according to claim 9, wherein said non-impurity ion irradiation is performed from said second region side.

13. The method of manufacturing a semiconductor device according to claim 9, wherein said single crystal substrate is composed of a semiconductor wafer of said first conductivity type, and said first and second regions are formed by allowing an impurity of said second conductivity type to diffuse into said semiconductor wafer in a predetermined depth.

14. The method of manufacturing a semiconductor device according to claim 9, further comprising the steps of:

connecting a collector electrode to said first region;
connecting an emitter electrode to said third and fourth regions; and
forming a gate electrode above said fourth region, with an insulating film interposed.

*FIG.1*

*FIG.2*

FIG.3

FIG.4

*FIG.5*

*FIG.6*

*FIG.7*

*FIG.8*

## FIG.9

## FIG.10

*FIG.11*

*FIG.12*

# INTERNATIONAL SEARCH REPORT

| | |
|---|---|
| International application No. | |
| PCT/JP98/05323 | |

**A. CLASSIFICATION OF SUBJECT MATTER**
Int.Cl⁶  H01L29/78

According to International Patent Classification (IPC) or to both national classification and IPC

**B. FIELDS SEARCHED**

Minimum documentation searched (classification system followed by classification symbols)
Int.Cl⁶  H01L29/78, H01L21/336, H01L21/322, H01L21/324

Documentation searched other than minimum documentation to the extent that such documents are included in the fields searched
Jitsuyo Shinan Koho          1964-1996     Toroku Jitsuyo Shinan Koho     1994-1999
Kokai Jitsuyo Shinan Koho    1971-1999     Jitsuyo Shinan Toroku Koho     1996-1999

Electronic data base consulted during the international search (name of data base and, where practicable, search terms used)
JOIS, (Donaa, Youshi, Puroton, Suiso, Herium, He, IGBT, Zetsuen Geeto, Sairisuta, GTO)

**C. DOCUMENTS CONSIDERED TO BE RELEVANT**

| Category* | Citation of document, with indication, where appropriate, of the relevant passages | Relevant to claim No. |
|---|---|---|
| Y | JP, 3-171777, A (Toshiba Corp.), 25 July, 1991 (25. 07. 91) & EP, 430237, A Page 4, lower left column, line 9 to page 5, upper left column, line 14 ; page 6, lower left column, line 11 to page 7, line 16 ; Figs. 1, 4 | 1-14 |
| Y | JP, 64-19771, A (Fuji Electric Co., Ltd.), 23 January, 1989 (23. 01. 89) (Family: none) Page 5, upper right column, lines 6 to 15 | 1-14 |
| Y | JP, 9-260662, A (Fuji Electric Co., Ltd.), 3 October, 1997 (03. 10. 97) (Family: none) Page 3, right column, lines 32 to 39 | 1-14 |
| Y | JP, 5-226661, A (Fuji Electric Co., Ltd.), 3 September, 1993 (03. 09. 93) (Family: none) Page 2, right column, line 46 to page 3, right column, line 8 ; Fig. 1 | 1-14 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | |
| "O" document referring to an oral disclosure, use, exhibition or other means | "Y" document of particular relevance; the claimed invention cannot be considered to involve an inventive step when the document is combined with one or more other such documents, such combination being obvious to a person skilled in the art |
| "P" document published prior to the international filing date but later than the priority date claimed | "&" document member of the same patent family |

| Date of the actual completion of the international search | Date of mailing of the international search report |
|---|---|
| 23 February, 1999 (23. 02. 99) | 2 March, 1999 (02. 03. 99) |

| Name and mailing address of the ISA/ | Authorized officer |
|---|---|
| Japanese Patent Office | |
| Facsimile No. | Telephone No. |

Form PCT/ISA/210 (second sheet) (July 1992)

EP 1 052 699 A1

# INTERNATIONAL SEARCH REPORT

International application No.

PCT/JP98/05323

C (Continuation). DOCUMENTS CONSIDERED TO BE RELEVANT

| Category* | Citation of document, with indication, where appropriate, of the relevant passages | Relevant to claim No. |
|---|---|---|
| Y | Tech. Dig. International Electron Devices Meeting Vol. 1985, P162-165 (1985) (USA), "Improved dynamic properties of GTO-thyristors and diodes by proton implantation", Full text ; Figs. 1 to 6 | 1-14 |
| Y | Physica B C Vol. 129, No. 1, P322-326 (1985) (NLD),"Buried recombination layers with enhanced n-type conductivity for silicon power devices", Full text ; Figs. 1 to 9 | 1-14 |
| Y | JP, 3-96281, A (Fuji Electric Co., Ltd.), 22 April, 1991 (22. 04. 91) (Family: none) Page 3, lower left column, line 17 to lower right column, line 19 ; Figs. 1, 2, 6 | 5-14 |
| Y | JP, 63-260174, A (Sanyo Electric Co., Ltd.), 27 October, 1988 (27. 10. 88) (Family: none) Page 2, lower left column, line 11 to page 3, lower left column, line 19 ; Fig. 1 | 5-14 |

Form PCT/ISA/210 (continuation of second sheet) (July 1992)